Europäisches Patentamt

European Patent Office

Office européen des brevets

(11) Numéro de publication : **0 014 115**
**B1**

(12) **FASCICULE DE BREVET EUROPÉEN**

(45) Date de publication du fascicule du brevet :
05.10.83

(51) Int. Cl.³ : **H 03 B   5/18**, H 03 H   2/00

(21) Numéro de dépôt : **80400033.9**

(22) Date de dépôt : **11.01.80**

(54) Oscillateur accordable hyperfréquence à ondes magnétostatiques.

(30) Priorité : **26.01.79 FR 7902096**

(43) Date de publication de la demande :
**06.08.80 Bulletin 80/16**

(45) Mention de la délivrance du brevet :
**05.10.83 Bulletin 83/40**

(84) Etats contractants désignés :
**DE GB NL SE**

(56) Documents cités :
**EP A 0 005 403**

**8th EUROPEAN MICROWAVE CONFERENCE, 4-8 septembre 1978, Paris Microwave exhibitions and publishers Ltd. Temple House Sevenoaks, Kent (GB) CASTERA et al. « Magnetostatic surface wave oscillators and resonators », pages 658-662**

**1978 IEEE INTERNATIONAL SYMPOSIUM ON CIRCUITS AND SYSTEMS PROCEEDINGS 17-19 mars 1978, New York, US OWENS et al. « Magnetostatic wave bandpass filters and resonators », pages 563-568**

**« Cours de Télévision » Eyrolles Editeur. Paris 1976 Ir. V. ALLAEYS p. 653**

(73) Titulaire : **THOMSON-CSF
173, Boulevard Haussmann
F-75379 Paris Cedex 08 (FR)**

(72) Inventeur : **Castera, Jean-Paul
"THOMSON-CSF" - SCPI 173, bld Haussmann
F-75360 Paris Cedex 08 (FR)**
Inventeur : **Dupont, Jean-Marie
"THOMSON-CSF" - SCPI 173, bld Haussmann
F-75360 Paris Cedex 08 (FR)**

(74) Mandataire : **Wang, Pierre et al
THOMSON-CSF SCPI 173, Bld Haussmann
F-75379 Paris Cedex 08 (FR)**

Jouve, 18, rue St-Denis, 75001 Paris, France

## Oscillateur accordable hyperfréquence à ondes magnétostatiques

L'invention concerne un oscillateur hyperfréquence, accordable par variation d'un champ magnétique, utilisant les ondes magnétostatiques pouvant se propager dans une couche mince de matériau magnétique.

Il est connu, en optique et en acoustique, de réfléchir une onde guidée dans une couche d'un matériau approprié par un réseau réalisé dans cette couche. Les vitesses de propagation des ondes lumineuses, comme celles des ondes acoustiques, sont liées aux caractéristiques du matériau constituant la couche et aux phénomènes physiques concernés. Le pas de la structure périodique définit la longueur d'onde des ondes susceptibles d'être réfléchies. On obtient un résonateur en réalisant deux réseaux entre lesquels les ondes peuvent se trouver en régime d'ondes stationnaires.

Pour obtenir des fréquences d'onde se situant dans la gamme des hyperfréquences (typiquement 1-10 GHz), on peut utiliser la propagation dans un matériau magnétique d'ondes dite magnétostatiques. Ces ondes, de type magnétique, sont dues au mouvement de l'aimantation dans le matériau. On les excite au moyen d'un transducteur dans lequel circule un courant hyperfréquence. La fréquence de résonance que l'on peut obtenir dans une cavité comprise entre deux réseaux est de l'ordre du GHz. Cette fréquence peut être rendue variable par modulation d'un champ magnétique extérieur. Un tel résonateur admet en général dans sa bande passante plusieurs modes d'oscillation, la distance en fréquence de ces modes étant inversement proportionnelle à ce que l'on appelle la longueur équivalente de la cavité. Pour une longueur donnée, le nombre de modes est déterminé par la bande passante de réflexion des réseaux. Cette technique est abordée dans l'article de J. P. Castera et P. Hartemann intitulé « Magnetostatic surface wave oscillators and resonators » paru aux pages 658-662 de la publication : 8th European Microwave Conference 4-8 Septembre 1978, Paris, Microwave exhibitions and publishers, Ltd Temple House Seven oaks, KENT (GB). L'article en question suggère notamment une structure d'oscillateur monomode à bouclage par deux lignes à retard en parallèle et une structure de résonateur à deux microrubans placés entre deux réseaux réflecteurs. Pour obtenir un oscillateur monomode à partir d'un tel résonateur, on pourrait théoriquement diminuer la valeur de la longueur équivalente afin qu'il ne subsiste qu'un seul mode dans cette bande passante. Toutefois, la diminution de cette valeur entraîne une baisse du coefficient de qualité du résonateur, incompatible avec des performances acceptables.

L'invention permet d'obtenir un oscillateur monomode avec un coefficient de qualité élevé et une bonne réjection des fréquences autres que la fréquence de résonance. Pour cela, il est prévu un résonateur à deux cavités couplées : l'énergie hyperfréquence est couplée dans la première cavité, qui est une cavité multimode à haut coefficient de qualité. La deuxième cavité, réalisée dans la même couche que la première, reçoit une partie de l'énergie mise en résonance dans la première. Les paramètres de la deuxième cavité sont choisis de manière à n'avoir qu'un seul mode dans la bande passante des réseaux, ce mode ayant la même fréquence que le mode principal de la première. On extrait une partie de l'énergie mise en résonance dans la deuxième cavité. Ce dispositif permet de bénéficier des avantages du haut coefficient de qualité de la première cavité en ne conservant qu'un seul mode, la deuxième cavité ayant un effet de filtrage. L'invention est notamment intéressante lorsqu'elle met en œuvre des ondes magnétostatiques de surface. En effet, ces ondes sont unidirectionnelles. Il est donc possible de ne coupler que les ondes se propageant dans un sens déterminé. L'invention peut aussi mettre en œuvre des ondes magnétostatiques de volume. On obtient alors un moins bon taux de réjection car l'unidirectionnalité n'existe plus, mais les puissances obtenues sont beaucoup plus élevées qu'avec des ondes de surface.

Selon l'invention, un oscillateur hyperfréquence, accordable par variation d'un champ magnétique, caractérisé en ce qu'il comprend deux cavités résonnantes couplées réalisées dans une couche de matériau magnétique et formant respectivement un premier résonateur utilisé comme filtre multimode et un deuxième résonateur utilisé comme filtre monomode, le deuxième résonateur filtrant l'un des modes propagés dans le premier, un transducteur d'entrée permettant de coupler des ondes magnétostatiques dans l'une des cavités, un transducteur de sortie permettant d'extraire un signal correspondant aux ondes propagées dans l'autre cavité, les deux transducteurs étant reliés par un circuit amplificateur et des moyens électromagnétiques permettant de soumettre les deux cavités à un champ magnétique extérieur ; lesdites cavités étant formées de trois réseaux de sillons parallèles de même pas ; l'un de ces réseaux étant commun auxdites cavités et les autres réseaux encadrant ledit réseau commun.

L'invention sera mieux comprise et d'autres caractéristiques apparaîtront à l'aide de la description ci-après et des figures annexées parmi lesquelles :

la figure 1 représente une cavité résonnante à deux réseaux, et son schéma équivalent ;

la figure 2 est le diagramme de fréquence d'un réseau de pas p ;

la figure 3 est le diagramme de fréquence d'une cavité de longueur équivalente $L_1$ ;

la figure 4 est le diagramme de fréquence d'une autre cavité de longueur équivalente $L_2$ ;

la figure 5 représente un oscillateur à deux cavités selon l'invention, utilisant les ondes de surface ;

la figure 6 est une vue de dessus de l'oscillateur de la figure 5 ;

la figure 7 est une vue en coupe de l'oscillateur de la figure 5 ;

les figures 8 et 9 représentent des oscillateurs utilisant les ondes de volume.

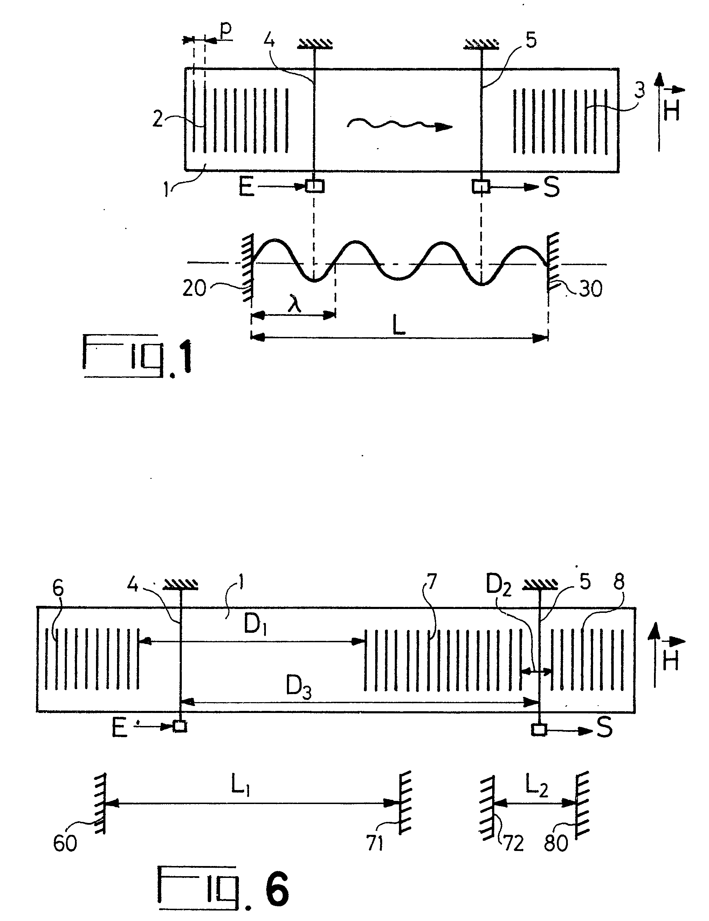

On peut voir sur la figure 1, la surface externe d'une couche magnétique 1, de grenat ferrimagnétique, par exemple un grenat d'yttrium-fer (YIG) déposé sur un substrat en grenat de gadoliniumgallium (GGG). La couche 1 est un milieu magnétique aimanté auquel on applique un champ magnétique $\vec{H}$ parallèle au plan de la couche. L'interaction entre le champ appliqué et l'aimantation permet la propagation dans le matériau d'ondes de surface, le matériau présentant de faibles pertes magnétiques. La direction de propagation est perpendiculaire au champ magnétique appliqué. Sur la surface de la couche 1, sont déposés deux réseaux 2 et 3 de sillons parallèles et équidistants de pas p, perpendiculaires à la direction de propagation. Entre les deux réseaux sont disposés un transducteur d'ondes magnétostatiques d'entrée 4 et un transducteur identique de sortie 5. Le transducteur 4 permet le couplage dans la couche magnétique 1 des ondes magnétostatiques. Le transducteur 5 permet d'extraire les ondes propagées dans la couche. L'ensemble formé entre les deux réseaux 2 et 3 constitue une cavité. En effet, les réseaux réfléchissant les ondes magnétostatiques dont la longueur d'onde $\lambda$ est égale à $\lambda_0 = 2$ p. Comme pour toute cavité, on peut définir pour chaque réseau un miroir équivalent : les miroirs 20 et 30 distants d'une longueur L qui est la longueur équivalente de la cavité. Entre les miroirs 20 et 30, s'établit un régime d'ondes stationnaires, la longueur d'onde $\lambda$ de ces ondes vérifiant la relation $L = n\lambda/2$ où n est un entier quelconque. Lorsque l'on couple dans la cavité une onde de longueur d'onde appropriée, on obtient un résonateur multimode, l'écart $\Delta f$ entre les modes qui est égal à $V/2L$, où v est la vitesse des ondes, permet de déterminer empiriquement la valeur de L qui est une caractéristique fondamentale du résonateur et qui dépend notamment de la distance entre les réseaux 2 et 3, de la profondeur d des sillons et du matériau magnétique. Pour obtenir un couplage efficace, il est nécessaire que les transducteurs d'entrée et de sortie se trouvent à l'emplacement d'un maximum des ondes stationnaires. C'est ainsi qu'ils ont été représentés sur la figure. On a réalisé un résonateur du type décrit à partir d'un substrat fait d'un grenat de gadolinium-gallium sur lequel on a déposé par croissance par épitaxie en phase liquide une couche 1 d'épaisseur 10 microns de grenat d'yttrium-fer pur. L'aimantation à saturation de la couche de YIG vaut 139 260 A/m (1 750 Oe). Le pas des réseaux a été choisi égal à 150 microns. Leurs sillons peuvent être obtenus par exemple par gravure, ou par bombardement d'ions provoquant des modifications locales sur une certaine épaisseur du matériau. La longueur d'onde des ondes échangées est alors de 300 microns. Le champ H appliqué a été initialement égal à 23 873 A/m (300 Oe). On obtient ainsi une fréquence de résonance égale à 2,6 GHz. Il s'agit là de la fréquence de résonance du mode principal, les autres modes étant distants en fréquence de la valeur $\Delta f$ définie plus haut. En faisant varier par exemple le champ magnétique appliqué de 7 957 A/m à 39 788 A/m (100 Oe à 500 Oe), la fréquence du mode principal varie de 1,9 GHz à 3,3 GHz.

La figure 2 représente le diagramme de réponse d'un réseau unique tel que le réseau 2 de pas p. L'équation de dispersion des ondes magnétostatiques de surface est :

$$k = 2\pi/\lambda = 1/2d\ L_n\ (2\pi M)^2/(H + 2\pi M)^2 - (f/\gamma)^2$$

où k et $\lambda$ sont respectivement le nombre d'onde et la longueur d'onde des ondes magnétostatiques, $L_n$ est la fonction logarithme népérien, $4\pi M$ est l'aimantation à saturation du matériau magnétique, H est le champ magnétique qui est appliqué parallèlement au plan de la couche, f est la fréquence des ondes magnétostatiques, et y est le rapport gyromagnétique ($\gamma = 35\ 185$ Hz m/A) ou ($\gamma = 2,8 \cdot 10^6$ Hz/Oe). De plus, $\lambda$ vérifie la relation $\lambda = \lambda_0/n$ où $\lambda_0 = 2p$. On peut voir sur la figure 2, en pointillés, la courbe C qui caractérise la transmission entre les deux transducteurs en fonction de la fréquence f d'après la relation de dispersion. La fréquence varie entre les fréquences de coupure $f_1$ correspondant à $k = 0$ et $f_2$ correspondant à $\lambda = 0$. Le diagramme de réponse se présente sous la forme de raies de fréquence $f_0$, $f_3$, $f_4$ correspondant respectivement aux longueurs d'onde $\lambda_0$, $\lambda_0/2$, etc... Il y a plusieurs raies de fréquence entre $f_1$ et $f_2$, la raie principale de fréquence $f_0$ correspondant à $\lambda_0$ est référencée $R_0$.

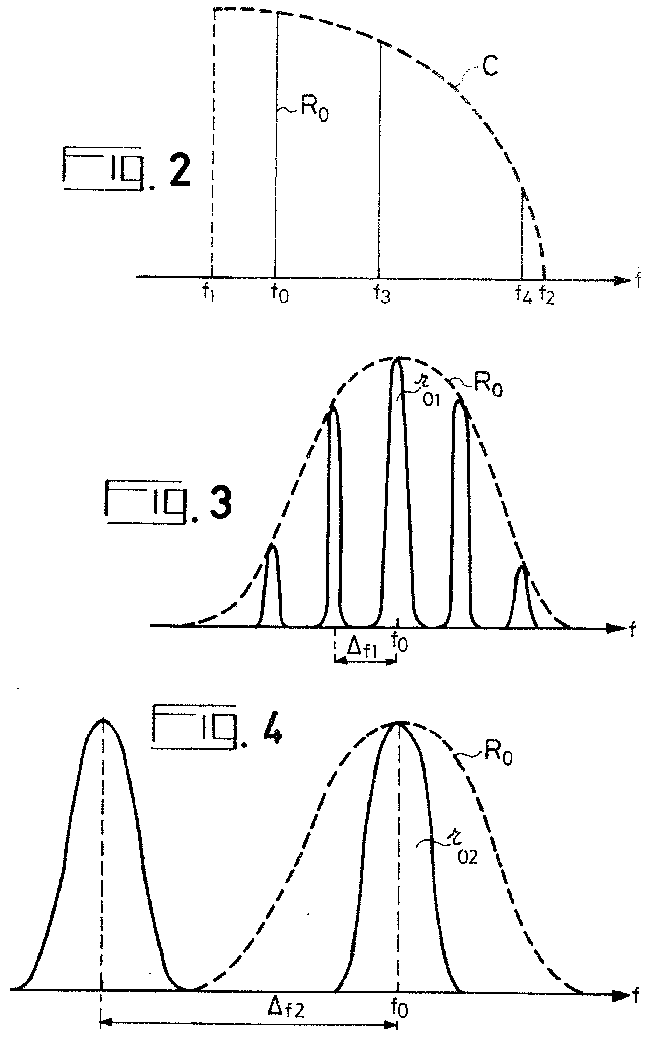

Cette raie $R_0$ est représentée à plus grande échelle sur la figure 3 en pointillés. Cette figure illustre le diagramme de réponse d'une cavité à deux réseaux telle que représentée sur la figure 1. A l'intérieur de la raie $R_0$, existent plusieurs modes correspondant à la relation $L_1 = n\lambda_0/2$ où $L_1$ est la longueur équivalente de la cavité. On obtient un mode principal $r_{01}$ pour la fréquence $f_0$ et d'autres modes de part et d'autre du mode principal équidistants d'une valeur $\Delta f_1$ définie par $\Delta f_1 = v/2L1$.

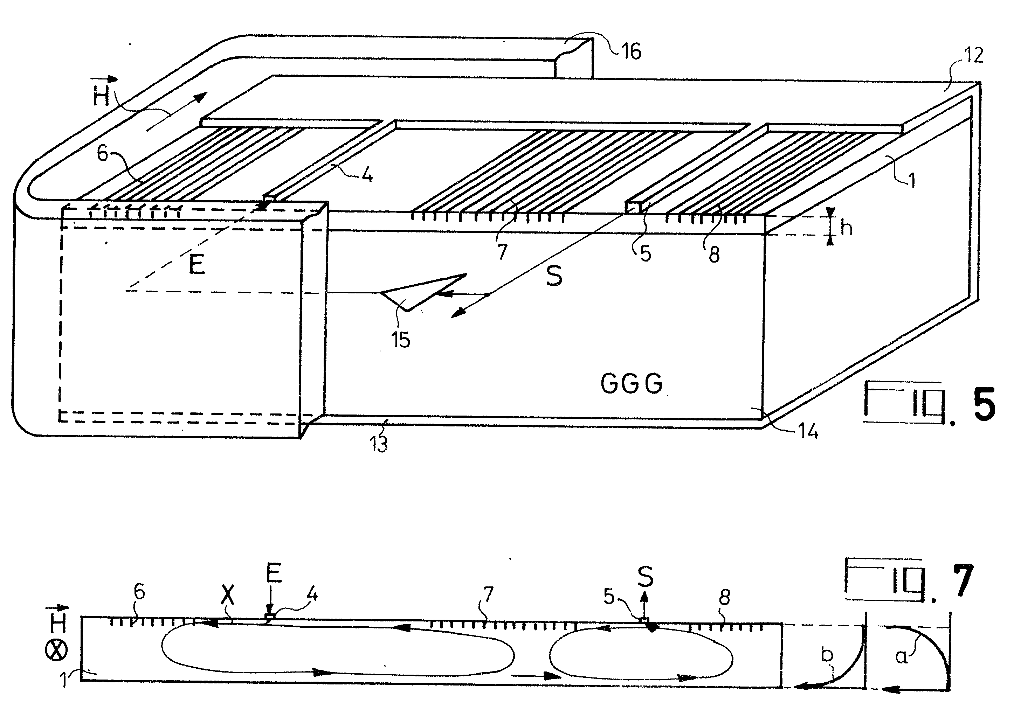

La figure 4 représente, à la même échelle que la figure 3, le diagramme de réponse d'une autre cavité utilisant les mêmes réseaux mais de longueur équivalente $L_2$ inférieure à la longueur précédente $L_1$. La courbe $R_0$ qui correspond à la réponse en réflexion des réseaux est identique à celle de la figure 3. Le mode principal $r_{02}$ est centré sur la même fréquence $f_0$ qui, on l'a vu, est liée au pas des réseaux. L'écart entre deux modes adjacents $\Delta f_2$ étant inversement proportionnel à la longueur de la cavité, il est plus grand que l'écart $\Delta f_1$. On voit sur la figure 4, que dans la gamme comprise dans la courbe $R_0$, il ne subsiste qu'un seul mode, mais que ce mode a une bande plus large que le mode principal de la figure 3. Ainsi il est possible d'obtenir un résonateur n'ayant qu'un seul mode dans la raie de réflexion principale en choisissant une longueur de cavité suffisamment faible, mais ceci se fait alors au détriment du coefficient de qualité du résonateur. L'invention, on le verra, permet d'obtenir un seul mode avec un résonateur ayant un coefficient de qualité aussi bon que celui d'une cavité de grande longueur.

La figure 5 est une vue d'un oscillateur selon l'invention. Il comprend un substrat 14 de GGG sur lequel est épitaxiée une couche 1 d'épaisseur h de YIG. L'ensemble est soumis à un champ magnétique H parallèle à la couche, obtenu par exemple par des moyens électromagnétiques classiques partiellement représentés 16. A la surface externe de la couche sont disposés des réseaux 6, 7 et 8 parallèles au champ H et de même pas, obtenus par exemple par bombardement ionique. Ces réseaux définissent deux cavités : l'une entre les réseaux 6 et 7 et l'autre entre les réseaux 7 et 8. Un signal E provenant d'un circuit amplificateur à résistance négative 15 est appliqué à un transducteur d'entrée 4 compris dans la première cavité à un endroit approprié comme défini plus haut et le signal de sortie S que l'on applique à l'entrée du circuit 15 est extrait d'un transducteur 5 disposé de même dans la deuxième cavité. Les deux transducteurs sont des bandes métalliques déposées sur la surface de YIG perpendiculairement au sens de propagation des ondes magnétiques donc parallèlement aux réseaux et au champ H. L'une des extrémités de chaque transducteur est reliée à une couche métallique 13 située sur la surface libre du substrat 14 et qui se prolonge en recouvrant une partie 12 de la surface extérieure de la couche YIG, en vue de la jonction avec les transducteurs 4 et 5. Dans certains cas, pour diminuer le couplage des ondes magnétostatiques dans les transducteurs il pourra être utile d'intercaler entre le YIG et les bandes métalliques formant les transducteurs une mince couche de silice formant isolant. Les ondes couplées par le transducteur 4 sont mises en résonance dans la première cavité entre les réseaux 6 et 7. Une partie des ondes non réfléchies dans le réseau 7 est transmise à la deuxième cavité entre les réseaux 7 et 8. Ce sont ces ondes mises en résonance dans la deuxième cavité qui sont extraites par le transducteur 5. Les longueurs des deux cavités sont choisies de façon que la première cavité se comporte comme un filtre multimode et ait un bon coefficient de qualité et que la deuxième se comporte comme un filtre monomode. Leurs diagrammes de réponse sont respectivement ceux des figures 3 et 4. La deuxième cavité est donc utilisée comme sélecteur de mode des ondes mises en résonance dans la première cavité. Les ondes extraites bénéficient du bon coefficient de qualité de la première cavité, tout en n'ayant qu'un seul mode dans la bande passante en réflexion des réseaux.

Les figures 6 et 7 sont des figures explicatives en plan de l'oscillateur représenté sur la figure 5.

La figure 6 est une vue de dessus sur laquelle sont également représentés les schémas équivalents des deux cavités, la première cavité étant constituée de deux miroirs 60 et 71 distants d'une longueur $L_1$, la deuxième cavité étant constituée de deux miroirs 72 et 80 distants d'une longueur $L_2$. L'oscillateur décrit a été réalisé avec une couche de YIG d'épaisseur h = 16 µm, des réseaux de sillons gravés de 2,8 µm de profondeur la longueur d'onde choisie était de 300 µm. Dans une telle couche, la vitesse de propagation des ondes est égale à $1,64 \cdot 10^5$ m/s. La distance $D_1$ entre les réseaux 6 et 7 était égale à 1 500 µm ; la distance $D_2$ entre les réseaux 7 et 8 égale au pas p, soit 150 µm. La distance entre les transducteurs 4 et 5 était égale à 3 000 µm et leur largeur à 50 µm. On a pu déterminer expérimentalement l'emplacement des miroirs équivalents et les longueurs des deux cavités : le miroir 80 est situé à 600 µm du transducteur 5 ; les miroirs 71 et 72 sont distants de 665 µm ; pour la première cavité $L_1 = 2\,730$ µm donnant un écart entre mode $\Delta f_1 = 30$ MHz ; pour la deuxième cavité $L_2 = 1\,230$ µm correspondant à $\Delta f_2 = 66,7$ MHz. La bande passante en réflexion des réseaux étant égale à 80 MHz, la première cavité a 3 modes dans cette bande alors que la deuxième cavité n'en a que un. On a fait varier le champ magnétique appliqué de façon à obtenir une variation de la fréquence de résonance entre 2 GHz et 4, 6 GHz. On constate que l'oscillateur n'a effectivement qu'une seule fréquence d'oscillation avec une réjection de 16 dB et un coefficient de qualité égal à 500. La plage de fréquence indiquée n'est qu'indicative et des plages plus grandes peuvent être obtenues.

La figure 7 est une vue en coupe de l'oscillateur selon l'invention. Elle montre le chemin emprunté par les ondes magnétostatiques de surface dans l'épaisseur de la couche. On sait que pour un sens donné du champ magnétique appliqué les ondes se propageant dans l'un des sens de propagation sont plutôt localisées à l'interface YIG-air et les ondes se propageant dans l'autre sens sont plutôt localisées à l'interface YIG-GGG. Les courbes a et b montrent la répartition d'énergie des ondes dans toute l'épaisseur de la couche respectivement pour les deux sens de propagation. Par conséquent pour coupler efficacement par le transducteur 4 les ondes dans la première cavité et dans cette cavité seulement, on choisira le sens du champ magnétique de façon que les ondes issues du transducteur 4 se dirigent dans le sens X vers le réseau 6. Les ondes sont ensuite mises en résonance entre les réseaux 6 et 7 dans le sens X à la surface extérieure du dispositif et dans le sens inverse à l'interface YIG-GGG, ce sont ces dernières ondes qui sont couplées dans la deuxième cavité. Ainsi le couplage est unidirectionnel et seules les ondes déjà mises en résonance dans la première cavité sont collectées par la deuxième, ce qui assure un bon coefficient de qualité. De même pour la deuxième cavité, seules les ondes se propageant dans le sens X sont recueillies par le transducteur 5 donc seules les ondes mises en résonance dans la deuxième cavité, c'est-à-dire filtrées donc n'ayant qu'un seul mode de résonance sont obtenues en sortie. Comme la deuxième cavité ne reçoit que des ondes de longueur d'onde $\lambda = \lambda_0 = 300\ \mu m$, au lieu de recevoir tout le spectre, la réjection des fréquences non situées dans la plage de résonance est augmentée par rapport à la réjection d'une cavité unique.

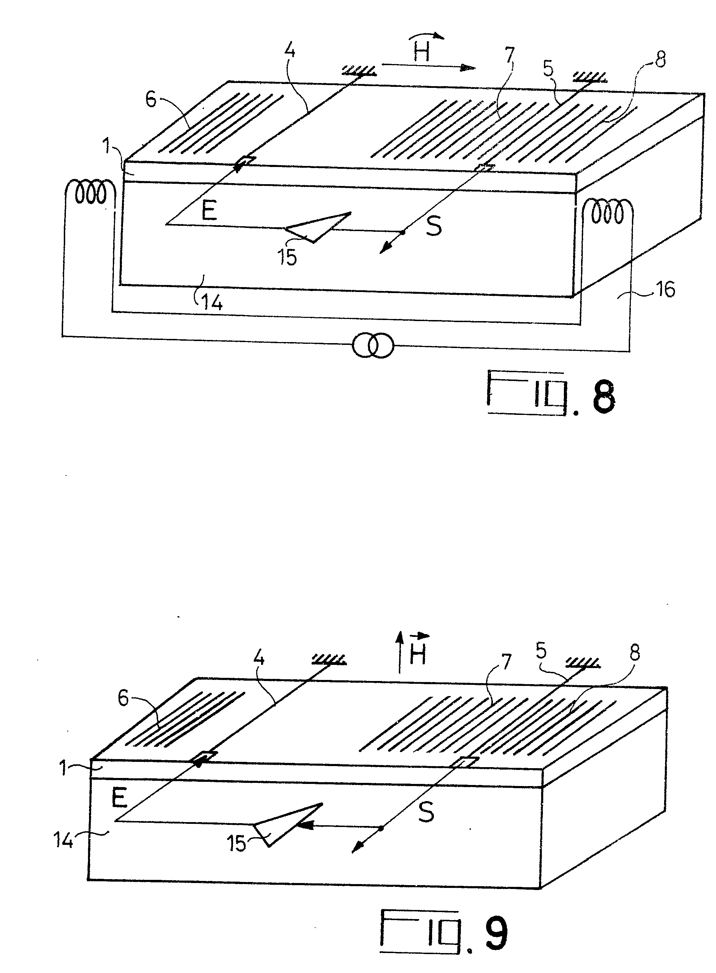

L'invention peut également utiliser les ondes magnétostatiques de volume. Ces ondes se produisent lorsque le champ appliqué est soit perpendiculaire à la couche de YIG, soit parallèle au plan de la couche et à la direction de propagation des ondes. La figure 8 montre un oscillateur à ondes de volume dans lequel le champ magnétique $\vec{H}$ est dans le plan de la couche et perpendiculaire aux sillons des réseaux. La figure 9 montre un oscillateur à ondes de volume dans lequel le champ magnétique $\vec{H}$ est perpendiculaire au plan de la couche. La structure de ces oscillateurs est très voisine de celle de l'oscillateur à ondes de surface représenté sur la figure 5. Dans les deux cas, l'unidirectionalité du couplage ne peut être conservée si bien que le taux de réjection obtenu est beaucoup moins bon que lorsqu'on utilise les ondes de surface. Par contre, la puissance que l'on peut obtenir en sortie est très supérieure à la puissance que l'on obtient avec les ondes de surface : typiquement, 20 mW au lieu de 100 μW. Le fonctionnement d'un résonateur à ondes de volume est à peu près semblable à celui expliqué précédemment. L'équation de dispersion et les règles de tels modes sont peu différentes, avec des vitesses de propagation différentes. Comme dans le cas précédent, les ondes sont sélectionnées par la première cavité, la deuxième cavité filtrant un seul mode parmi les quelques modes de la première cavité.

## Revendications

1. Oscillateur hyperfréquence, accordable par variation d'un champ magnétique, caractérisé en ce qu'il comprend deux cavités résonnantes (6-7), (7-8), couplées réalisées dans une couche de matériau magnétique (1) et formant respectivement un premier résonateur utilisé comme filtre multimode et un deuxième résonateur utilisé comme filtre monomode, le deuxième résonateur filtrant l'un des modes propagés dans le premier, un transducteur d'entrée (4) permettant de coupler des ondes magnétostatiques dans l'une des cavités, un transducteur de sortie (5) permettant d'extraire un signal correspondant aux ondes propagées dans l'autre cavité, les deux transducteurs (4), (5) étant reliés par un circuit amplificateur (15) et des moyens électromagnétiques (16) permettant de soumettre les deux cavités à un champ magnétique extérieur $\vec{H}$ ; lesdites cavités étant formées de trois réseaux (6), (7), (8) de sillons parallèles de même pas ; l'un de ces réseaux (7) étant commun auxdites cavités et les autres réseaux (6), (8) encadrant ledit réseau commun.

2. Oscillateur selon la revendication 1, caractérisé en ce que le matériau magnétique (1) est un grenat d'yttrium-fer déposé en couche sur un substrat en grenat de gadolinium-gallium (14).

3. Oscillateur selon l'une quelconque des revendications 1 et 2, caractérisé en ce que le transducteur d'entrée (4) et le transducteur de sortie (5) sont formés de bandes métalliques déposées sur la couche (1) respectivement dans la première cavité et dans la deuxième cavité ; lesdites bandes métalliques ayant une extrémité reliée à une masse commune (12) et l'autre extrémité respectivement à l'entrée et à la sortie du circuit amplificateur (15).

4. Oscillateur selon l'une quelconque des revendications 1 à 3, caractérisé en ce que la direction du champ magnétique $\vec{H}$ est parallèle au plan de la couche et perpendiculaire à la direction de propagation des ondes, et son sens est tel que le transducteur d'entrée (4) ne couple dans la première cavité (6-7) que les ondes se propageant en s'éloignant de la deuxième cavité.

5. Oscillateur selon l'une quelconque des revendications 1 à 3, caractérisé en ce que le champ magnétique $\vec{H}$ est parallèle au plan de la couche et parallèle à la direction de propagation des ondes.

6. Oscillateur selon l'une quelconque des revendications 1 à 3, caractérisé en ce que le champ magnétique $\vec{H}$ est perpendiculaire au plan de la couche.

## Claims

1. An UHF oscillator which can be tuned by variation of a magnetic field, characterized in that it comprises two coupled resonance cavities (6-7), (7-8) which are realized in a layer (1) of magnetic material and which constitute respectively a first resonator employed as a multimode filter and a second resonator employed as a monomode filter, the second resonator filtering one of the modes which are propagated in the first resonator, an input transducer (4) being provided which permits to couple magnetostatic waves into one of the cavities, an output transducer (5) being provided which permits to extract a signal corresponding to the waves propagated in the other cavity, the two transducers (4), (5) being connected by an amplification circuit (15), and electromagnetic means (16) being provided which allow the two cavities to be submitted to an exterior magnetic filed $\vec{H}$, the said cavities being constituted by three nets (6), (7), (8) of equidistant parallel furows, one of these nets (7) being common to the said cavities whereas the others (6), (8) flank the common net.

2. An oscillator according to claim 1, characterized in that the magnetic material (1) is an yttrium-iron-garnet which is put as a layer on a substrate made of gadolinium-gallium-garnet (14).

3. An oscillator according to any one of the claims 1 and 2, characterized in that the input transducer (4) and the output transducer (5) are made of metal strips which are deposited on the layer (1) of the first and the second cavity respectively, one end of these strips being connected to a common earth (12) and the other end being connected to the input and output respectively of the amplification circuit (15).

4. An oscillator according to any one of the claims 1 to 3, characterized in that the direction of the magnetic field $\vec{H}$ is parallel to the layer plane and perpendicular to the direction of the wave propagation, the sense being such that the input transducer (4) only couples into the first cavity (6-7) the waves which travel away from the second cavity.

5. An oscillator according to any one of the claims 1 to 3, characterized in that the magnetic field $\vec{H}$ is parallel to the layer plane and to the direction of the wave propagation.

6. An oscillator according to any one of the claims 1 to 3, characterized in that the magnetic field $\vec{H}$ is perpendicular to the layer plane.

## Ansprüche

1. Hyperfrequenzoszillator, der durch Veränderung eines Magnetfeldes abgestimmt werden kann, dadurch gekennzeichnet, daß er zwei gekoppelte Resonanzhohlräume (6-7), (7-8) aufweist, die in einer Schicht (1) aus magnetischem Material realisiert sind und einen ersten als Multimodefilter verwendeten bzw. einen zweiten als Monomodefilter verwendeten Resonator bilden, wobei der zweite Resonator einen der Modes, die im ersten Resonator übertragen werden, filtert und ein Eingangstransduktor (4) magnetostatische Wellen in einem der Hohlräume zu koppeln vermag, während ein Ausgangstransduktor (5) ein den im anderen Hohlraum übertragenen Wellen entsprechendes Signal zu entnehmen vermag, wobei die beiden Transduktoren (4), (5) über einen Verstärkungsschaltkreis (15) miteinander verbunden sind und elektromagnetische Mittel (16) in der Lage sind, die beiden Hohlräume einem äußeren Magnetfeld $\vec{H}$ auszusetzen, wobei diese Hohlräume von drei Netzen (6), (7), (8) von parallelen Rillen gleichen Abstands gebildet werden und eines der Netze (7) beiden Hohlräumen zugehört, während die anderen Netze (6), (8) dieses gemeinsame Netz einrahmen.

2. Oszillator nach Anspruch 1, dadurch gekennzeichnet, daß das magnetische Material ein Yttrium-Eisen-Granat ist, das als Schicht auf einen Träger aus Gadolinium-Gallium (14) aufgebracht ist.

3. Oszillator nach einem beliebigen der Ansprüche 1 und 2, dadurch gekennzeichnet, daß der Eingangstransduktor (4) und der Ausgangstransduktor (5) von Metallbändern gebildet werden, die auf die Schicht (1) im ersten bzw. zweiten Hohlraum aufgebracht sind, wobei diese Metallbänder mit einem Ende an eine gemeinsame Masse (12) und mit dem anderen Ende an den Eingang bzw. den Ausgang des Verstärkungsschaltkreises (15) angeschlossen sind.

4. Oszillator nach einem beliebigen der Ansprüche 1 bis 3, dadurch gekennzeichnet, daß die Richtung des Magnetfelds $\vec{H}$ parallel zur Ebene der Schicht und senkrecht zur Fortpflanzungsrichtung der Wellen liegt, und zwar so, daß der Eingangstransduktor (4) in den ersten Hohlraum (6-7) nur die Wellen einkoppelt, die sich vom zweiten Hohlraum entfernend verlaufen.

5. Oszillator nach einem beliebigen der Ansprüche 1 bis 3, dadurch gekennzeichnet, daß das Magnetfeld $\vec{H}$ parallel zur Ebene der Schicht und parallel zur Fortpflanzungsrichtung der Wellen ausgerichtet ist.

6. Oszillator nach einem beliebigen der Ansprüche 1 bis 3, dadurch gekennzeichnet, daß das Magnetfeld $\vec{H}$ senkrecht zur Ebene der Schicht ausgerichtet ist.

**Fig.1**

**Fig. 6**

0 014 115

Fig. 2

Fig. 3

Fig. 4

2

Fig. 5

Fig. 7

Fig. 8

Fig. 9